# EUROPÄISCHE PATENTSCHRIFT

(11) **EP 3 841 649 B1**
(45) Veröffentlichungstag und Bekanntmachung des Hinweises auf die Patenterteilung: **09.09.2026**
(21) Anmeldenummer: 19748808.3
(22) Anmeldetag: 31.07.2019
(51) Int. Cl.: H02J 3/38, G01R 23/177, G01R 19/25

(54) **WINDENERGIEANLAGE UND VERFAHREN ZUM ERKENNEN NIEDERFREQUENTER SCHWINGUNGEN IN EINEM ELEKTRISCHEN VERSORGUNGSNETZ**
WIND TURBINE AND METHOD FOR DETECTING LOW-FREQUENCY VIBRATIONS IN AN ELECTRIC SUPPLY NETWORK
ÉOLIENNE ET PROCÉDÉ POUR DÉTECTER DES OSCILLATIONS DE BASSE FRÉQUENCE DANS UN RÉSEAU D'ALIMENTATION ÉLECTRIQUE

(30) Priorität: 24.08.2018 DE 102018120751
(43) Veröffentlichungstag der Anmeldung: 30.06.2021
(73) Patentinhaber: Wobben Properties GmbH, 26607 Aurich (DE)
(72) Erfinder: BROMBACH, Johannes, 13437 Berlin (DE)
(74) Vertreter: Eisenführ Speiser
(86) Internationale Anmeldenummer: PCT/EP2019/070611
(87) Internationale Veröffentlichungsnummer: WO 2020/038692

(56) Entgegenhaltungen:
- WO-A2-2012/000514
- US-A1- 2009 099 798

## Beschreibung

Die vorliegende Erfindung betrifft ein Verfahren zum Erkennen niederfrequenter Schwingungen, insbesondere subsynchroner Resonanzen, in einem elektrischen Versorgungsnetz. Die vorliegende Erfindung betrifft auch ein Windenergiesystem, nämlich eine Windenergieanlage oder einen Windpark, zum Erkennen niederfrequenter Schwingungen, insbesondere subsynchroner Resonanzen in einem elektrischen Versorgungsnetz.

Viele elektrische Versorgungsnetze weisen zunehmend regenerative Energieerzeuger, insbesondere Windenergieanlagen oder Windparks auf. Ihr steigender Anteil im elektrischen Versorgungsnetz führt dazu, dass es auch zunehmend wichtiger wird, Windenergieanlagen und Windparks zum Stützen des elektrischen Versorgungsnetzes zu verwenden, oder zumindest mit zu berücksichtigen.

Ein Problem, das im elektrischen Versorgungsnetz, das auch vereinfachend als Netz bezeichnet werden kann, auftreten kann, sind Schwingungen, nämlich Schwingungen des Energiesystems, die auch als *"Power System Oscillations"* (PSO) bezeichnet werden können. Ihre Ursache kann sehr vielfältig sein und ein anschauliches und einfaches Beispiel ist, dass zwei direkt gekoppelte Synchrongeneratoren konventioneller Kraftwerke, die beispielsweise über 100 Kilometer voneinander entfernt einspeisen, gegeneinander schwingen. Es kommt aber auch in Betracht, dass bereits ein einzelner direkt mit dem elektrischen Versorgungsnetz gekoppelter Synchrongenerator aufgrund einer lokalen Anregung, wie einem Sprung der Leistungsabnahme der angeschlossenen Verbraucher, angeregt wird, mit seiner Eigenfrequenz zu schwingen. Herkömmliche elektrische Versorgungsnetze begegnen solchen Problemen regelmäßig durch entsprechend stabile Regelungen der direkt in das elektrische Versorgungsnetz einspeisenden Synchrongeneratoren. Eine hohe Trägheit dieser Synchrongeneratoren zusammen mit einem physikalisch bedingten und/oder durch den konstruktiven Aufbau des jeweiligen Generators bedingten Dämpfungsverhalten verhindert bei herkömmlichen Netzen regelmäßig ein zu starkes Auftreten solcher Schwingungen.

Regenerative Erzeuger, insbesondere Windenergieanlagen oder Windparks, weisen aber von sich aus solche Eigenschaften nicht auf. Insbesondere weisen sie praktisch keine physikalisch bedingten Eigenschaften auf, die solchen niederfrequenten Schwingungen entgegenwirken können, oder solche niederfrequenten Schwingungen von vornherein vermeiden könnten.

Stattdessen speisen moderne Windenergieanlagen oder Windparks heutzutage mittels Frequenzumrichtern unter Verwendung eines sogenannten Vollumrichterkonzepts in das elektrische Versorgungsnetz ein. Demnach wird die gesamte eingespeiste Leistung durch den, bzw. die Wechselrichter nach genauen Vorgaben in das elektrische Versorgungsnetz eingespeist. Diese Vorgaben betreffen besonders Amplitude, Frequenz und Phase des eingespeisten elektrischen Stroms und diese Vorgabe kann über einen Prozessrechner vorgegeben werden. Dabei ist wenig Raum für physikalisch bedingte Reaktionen oder Anpassungen des eingespeisten Stroms.

Um dennoch auf Phänomene im elektrischen Versorgungsnetz reagieren zu können, insbesondere, um auf niederfrequente Schwingungen, also sogenannte PSO reagieren zu können, müssten solche Schwingungen somit zunächst erfasst werden, idealerweise nach Frequenz, Phasenlage und Amplitude. Darauf basierend könnte dann in den Prozessrechner eine gewünschte Reaktionsmaßnahme berechnet werden, um diese dann mittels des Wechselrichters umzusetzen.

Sofern eine solche niederfrequente Schwingung aber nicht ausreichend genau erfasst wird, können etwaige Gegenmaßnahmen sogar die aktuelle Situation verschlechtern. Dabei kann eine solche Erfassung niederfrequenter Schwingungen schwierig sein, weil diese niederfrequenten Schwingungen zunächst mit vergleichsweise geringer Amplitude der Netzfrequenz, also dem 50 Hz oder 60 Hz Spannungssignal im elektrischen Versorgungsnetz überlagert ist. Besonders bei der Spannungsmessung im elektrischen Versorgungsnetz kommt hinzu, dass mit Störungen und/oder Rauschen zu rechnen ist. Zudem fluktuieren solche niederfrequenten Schwingungen regelmäßig. Besonders treten sie je nach Anregung schwach oder stark oder gar nicht auf.

Trotz dieser Messprobleme ist aber eine möglichst schnelle Erfassung wünschenswert. Das steht wiederum einer längerfristigen Analyse entgegen.

Es kommt das Problem hinzu, dass solche niederfrequenten Schwingungen in einem Frequenzbereich von 0,05 Hz, oder sogar noch niedriger, bis hin zu Frequenzwerten kurz unter der Netzfrequenz liegen können, also bis zur Größenordnung von 50 bis 60 Hz. Rein physikalisch bedingt benötigt die Erfassung einer sinusförmigen Schwingung eine Messung über die Zeitdauer wenigstens einer Halbwelle dieser Schwingung. Bei einem großen Frequenzspektrum ist zu dessen Erfassung somit eine Messdauer zumindest über eine Halbwelle der Schwingung mit der geringsten zu erwartenden Frequenz erforderlich.

Das Deutsche Patent- und Markenamt hat in der Prioritätsanmeldung zu vorliegender Anmeldung folgenden Stand der Technik recherchiert: US 2017/0276539 A1.

Das Dokument US 2009/0099798 A1 betrifft zur Verwendung in einem elektrischen Energiesystem eine Vorrichtung zur Erkennung von Netzschwingungen. Über mehrere intelligente elektronische Geräte (IEDs), die mit dem Stromnetz kommunizieren, werden mehrere Beispielsignale vom Stromnetz erfasst. Das Gerät zur Erkennung von Schwingungen des Stromversorgungssystems umfasst ein Echtzeit-Modalanalysemodul, ein Echtzeit-Modusidentifizierungsmodul sowie eine Echtzeit-Entscheidungs- und Steuerlogik.

Der vorliegenden Erfindung liegt somit die Aufgabe zugrunde, zumindest eins der oben genannten Probleme zu adressieren. Insbesondere soll eine Lösung vorgeschlagen werden, die eine möglichst schnelle Erfassung niederfrequenter Schwingungen ermöglicht, während sie gleichzeitig auch sehr niederfrequente Schwingungen erfassen kann. Zumindest soll zu bisher bekannten Lösungen eine alternative Lösung vorgeschlagen werden.

Erfindungsgemäß wird ein Verfahren nach Anspruch 1 vorgeschlagen. Dieses Verfahren dient zum Erkennen niederfrequenter Schwingungen in einem elektrischen Versorgungsnetz, insbesondere zum Erkennen subsynchroner Resonanzen in einem elektrischen Versorgungsnetz. Dabei wird von einem elektrischen Versorgungsnetz ausgegangen, das eine Netzspannung mit einer Netznennfrequenz aufweist, wobei die zu erkennenden niederfrequenten Schwingungen vorzugsweise eine geringere Frequenz als die Netznennfrequenz aufweisen. Hier wird also insbesondere als niederfrequente Schwingung bezeichnet und betrachtet, was eine geringere Frequenz als die Netznennfrequenz hat. Vorzugsweise wird von einer Frequenz der niederfrequenten Schwingungen ausgegangen, die kleiner als die halbe Netznennfrequenz ist.

Besonders können die niederfrequenten Schwingungen Werte von 1 Hz und weniger aufweisen. Sie können aber auch bis zum fünffachen Wert der Netznennfrequenz reichen. Als niederfrequente Schwingungen werden hier Schwingungen mit einer Frequenz von maximal dem fünffachen Wert der Netznennfrequenz bezeichnet, vorzugsweise mit einer Frequenz die maximal der Netznennfrequenz entspricht. Besonders weist die niederfrequente Schwingung keine Frequenz auf, die einem Vielfachen der Netznennfrequenz entspricht. Es ist zu beachten, dass die Untersuchung und Berücksichtigung niederfrequenter Schwingungen besonders der Untersuchung oder dem Sicherstellen einer Systemstabilität des elektrischen Versorgungsnetzes dient. Das grenzt sich von einer Beurteilung der Netzqualität bzw. Signalqualität des Spannungssignals im elektrischen Versorgungsnetz ab, bei der es besonders auf Oberwellen ankommt.

Das Verfahren schlägt vor, eine erste und eine zweite Messreihe aufzunehmen, jeweils zum Durchführen einer Frequenzanalyse, insbesondere zum Durchführen einer FFT.

Dazu wird nun das Durchführen einer unteren Frequenzanalyse für die erste Messreihe für einen unteren Frequenzbereich vorgeschlagen, wobei für den unteren Frequenzbereich ein unteres Amplitudenspektrum gebildet wird. Bei dieser unteren Frequenzanalyse wird somit die erste Messreihe ausgewertet und die Auswertung erfolgt so, dass sie auf einen unteren Frequenzbereich gerichtet ist. Besonders bei der Verwendung einer FFT wird eine Grundfrequenz oder unterste Frequenz vorgegeben und durch die verwendete Abtastrate wird gleichzeitig ein oberer Frequenzwert festgelegt und dadurch kann der untere Frequenzbereich der unteren Frequenzanalyse festgelegt werden. Die entsprechende Abtastrate kann auch schon beim Aufnehmen, besonders beim Messen, der jeweiligen Messreihe berücksichtigt werden.

Außerdem wird das Durchführen einer oberen Frequenzanalyse für die zweite Messreihe für einen oberen Frequenzbereich vorgeschlagen, wobei für den oberen Frequenzbereich ein oberes Amplitudenspektrum gebildet wird. Auch hier kann der obere Frequenzbereich sinngemäß wie der untere Frequenzbereich festgelegt oder vorgegeben werden. In beiden Fällen wird ein Amplitudenspektrum gebildet, nämlich ein unteres und ein oberes.

In beiden Amplitudenspektren, also im oberen und im unteren, wird jeweils geprüft, ob ein niederfrequenter Schwingungsanteil identifiziert werden kann. Wenn das der Fall ist, wird vom Vorliegen einer niederfrequenten Schwingung ausgegangen. Es wird also vom Vorliegen einer niederfrequenten Schwingung ausgegangen, wenn in wenigstens einem der Amplitudenspektren ein niederfrequenter Schwingungsanteil identifiziert wurde. Sollte in beiden wenigstens ein niederfrequenter Schwingungsanteil identifiziert worden sein, so ist dann natürlich auch vom Vorliegen einer niederfrequenten Schwingung auszugehen. Ob diese niederfrequente Schwingung dabei zusätzlich als subsynchrone Oszillation identifiziert werden kann, kann von weiteren Informationen abhängen, wie der Frequenz des identifizierten niederfrequenten Schwingungsanteils und gegebenenfalls dem betrachteten elektrischen Versorgungsnetz. Insbesondere kommt in Betracht, dass an einem Netzanschlusspunkt, in dem die Messreihen aufgenommen werden, subsynchrone Resonanzen mit einer bekannten Frequenz auftreten können. Das kann beispielsweise aus einer Netzanalyse oder aus früheren Frequenzanalysen bekannt sein. Dann kann, wenn ein niederfrequenter Schwingungsanteil identifiziert wurde, überprüft werden, ob dieser einer bekannten zu erwartenden subsynchronen Oszillation entspricht.

Der vorgeschlagenen Lösung liegt besonders der Gedanke zugrunde, dass für den unteren und oberen Frequenzbereich unterschiedliche Randbedingungen für die Messung zugrunde liegen und auch zugrunde gelegt werden können. So kann der untere Frequenzbereich eine längere Messdauer, insbesondere ein längeres Messfenster, bei gleichzeitig aber geringerer Abtastrate sinnvoll machen, wohingegen für den höheren, also oberen Frequenzbereich eine geringere Messdauer ausreichen kann, aber eine höhere Abtastrate, also höhere Abtastfrequenz, notwendig sein kann. Gegebenenfalls kann das dazu führen, dass in dem oberen Frequenzbereich schneller eine niederfrequente Schwingung mit vergleichsweise hoher Frequenz erfasst wird, als für den unteren Frequenzbereich eine niederfrequente Schwingung mit geringerer Frequenz erfasst wird. Dabei liegt aber die Erkenntnis zugrunde, dass es bei der niederfrequenten Schwingung geringer Frequenz auch ausreichend sein kann, diese nicht so schnell zu erfassen wie eine niederfrequente Schwingung höherer Frequenz.

Erfindungsgemäß wird vorgeschlagen, dass die erste Messreihe über einen längeren Zeitraum als die zweite Messreihe aufgenommen wird oder ausgewertet wird, und dass außerdem, oder alternativ, die erste Messreihe mit einer geringeren Abtastrate als die zweite Messreihe aufgenommen wird oder ausgewertet wird.

Dem liegt die Erkenntnis zugrunde, dass die unterschiedlichen Frequenzbereiche unterschiedliche Messzeiträume und Abtastraten zulassen. Für die erste Messreihe und damit den unteren Frequenzbereich kann länger gemessen werden, weil auch die zu erfassenden Schwingungen langsamer sind. dabei ist es aber möglich, für die zweite Messreihe und damit den oberen Frequenzbereich schneller zu messen, um damit auch schneller ein Ergebnis zu bekommen.

Gleichzeitig wurde erkannt, dass besonders bei einer längeren Messung bei gleicher Abtastrate entsprechend mehr Messwerte aufgenommen werden würden. Es wurde aber erkannt, dass für die Analyse des unteren Frequenzbereichs eine geringere Abtastrate ausreichend sein kann als für die Analyse des oberen Frequenzbereichs. Daher werden die unterschiedlichen Zeiträume bzw. unterschiedlichen Abtastraten vorgeschlagen.

Insbesondere wird vorgeschlagen, dass die erste Messreihe über einen ersten Zeitraum aufgenommen wird, der in einem Bereich von 1 bis 10 Minuten liegt. Daraus ergibt sich aus dem Kehrwert eine Frequenzauflösung von 1/600 Hz bis 1/60 Hz

Außerdem, oder alternativ, wird vorgeschlagen, dass die zweite Messreihe über einen zweiten Zeitraum aufgenommen wird, der in einem Bereich von 1 bis 10 Sekunden liegt. Besonders wurde hier auch erkannt, dass die zu erfassenden niederfrequenten Schwingungen zwar in einem Frequenzbereich unterhalb der Netznennfrequenz liegen, also unterhalb von 50 Hz oder unterhalb von 60 Hz, dass aber gleichwohl der zu untersuchende Frequenzbereich, der beispielsweise etwa von 0,5 bis 50 Hz liegen kann, einen sehr großen Bereich umfasst. Hier kann die größte zu erwartende Frequenz in der Größenordnung von etwa 1000fach so groß sein wie die kleinste zu erwartende Frequenz, oder noch größer. Es wurde auch erkannt, dass besonders der erste Frequenzbereich, der zum Beispiel von 0,05 Hz bis 0,5 Hz liegen kann, einen Messzeitraum von 1 bis 10 Minuten sinnvoll machen kann, wohingegen ein Messzeitraum von mehreren Minuten für den zweiten Frequenzbereich, der beispielsweise von 0,5 bis knapp 50 Hz liegen kann, sehr lang wäre und besonders bereits viele Schwingzyklen einer niederfrequenten Schwingung mit vergleichsweise hoher Frequenz, wie beispielsweise 10 Hz, zulassen würde, bevor dieser erfasst wäre. Daher wird für die zweite Messreihe, also für die Erfassung des zweiten Frequenzbereichs, ein so kurzer zweiter Zeitraum von 1 bis 10 Sekunden vorgesehen.

Gemäß einer Ausführungsform wird vorgeschlagen, dass das Verfahren dadurch gekennzeichnet ist, dass als erste Messreihe eine Frequenzmessung aufgenommen wird, sodass das erste Amplitudenspektrum Frequenzamplituden in Abhängigkeit einer Frequenz angibt, und dass als zweite Messreihe eine Spannungsmessung aufgenommen wird, sodass das zweite Amplitudenspektrum Spannungsamplituden in Abhängigkeit einer Frequenz angibt.

Das erste Amplitudenspektrum ist also ein Frequenzamplitudenspektrum, wohingegen das zweite Amplitudenspektrum ein Spannungsamplitudenspektrum ist. Als erste Messreihe wird somit eine Frequenz erfasst und das kann auch über eine Spannungsmessung erfolgen, wobei aber von dieser Spannungsmessung dann nur der Frequenzverlauf betrachtet wird, bzw. die Spannungsmessung wird zunächst in eine Frequenzmessung oder Reihe aus Frequenzwerten umgewandelt. Eine solche Messreihe wird beispielsweise im Falle einer Netznennfrequenz von 50 Hz ein Zeitsignal, bzw. entsprechend diskretes Signal mit einem Wert von etwa 50 Hz aufweisen. Diese erste Messreihe kann in einem Diagramm über eine Zeitachse aufgetragen werden, und das ergäbe somit im Wesentlichen eine waagerechte Linie bei 50 Hz. Darin können aber, wenn kein Idealfall vorliegt, leichte Abweichungen vorkommen. Das heißt, diese etwa waagerechte Linie bei 50 Hz weist doch einige, leichte Schwingungen auf. Die somit Schwankungen der Netzfrequenz anzeigen. Schwankt beispielsweise die Netzfrequenz in 10 Sekunden von 49,5 Hz bis 50,5 Hz und wieder zurück, um ein anschauliches Beispiel zu nehmen, so entspricht dies in dem Frequenzamplitudenspektrum einem Wert der Amplitude 0,5 Hz bei einer Frequenz von 0,1 Hz. In einer grafischen Darstellung wäre dies also bei einem Wert von 0,1 Hz an der Abszisse eine Amplitude von 0,5 Hz an der Ordinate. Bei dem genannten Beispiel würde sich in dem Frequenzamplitudenspektrum im Übrigen auch bei 0 Hz, also bei dem Wert 0 an der Abszisse, eine Amplitude von 50 Hz, also 50 Hz an der Ordinate, einstellen. Das ist nämlich der Wert für die Grundfrequenz von 50 Hz, die hier als Gleichanteil auftritt. Das Ausgangssignal war schließlich ein über die Zeit im Wesentlichen konstanter Wert von 50 Hz, mit kleinen überlagerten Schwankungen.

Die zweite Messreihe kann dabei beispielsweise unmittelbar, beispielsweise über ein FFT, in ein Spannungsamplitudenspektrum gewandelt werden. Dieses Spannungsamplitudenspektrum würde entsprechend den größten Wert bei 50 Hz aufweisen, der bei dem Spannungsamplitudenspektrum für die Grundfrequenz steht.

Hiermit kann besonders durch die erste Messreihe, die als Frequenzmessung ausgebildet ist, bzw. durch das erste Amplitudenspektrum, das als Frequenzamplitudenspektrum ausgebildet ist, eine gute Erkennung besonders sehr niedriger Frequenzen, die besonders in einem Bereich von unter 0,5 Hz liegen, erreicht werden. Eine solche erste Messreihe erfordert aber eine vergleichsweise lange Messung, um überhaupt diese Frequenzschwankungen auswertbar aufnehmen zu können. Beispielsweise wird ein Messbereich von 1 bis 10 Minuten auch für diese Art der ersten Messreihe vorgeschlagen.

Die zweite Messreihe kann deutlich schneller aufgenommen werden, ihr kann also ein kürzerer Messzeitraum zugrunde liegen, der im Bereich von 1 bis 10 Sekunden liegen kann. Damit können schnell niederfrequente Schwingungen erkannt werden, die aber gleichwohl eine deutlich höhere Frequenz aufweisen, als in dem unteren Frequenzbereich enthalten sind.

Vorzugsweise wird für die Auswertung der Frequenzamplituden als Frequenzanalyse oder Teil davon eine Häufigkeit oder Häufigkeitsdichte der Frequenz oder eines Frequenzgradienten der Frequenz erfasst. Über diese Häufigkeit oder Häufigkeitsdichte kann dann Rückschluss auf eine in der zu Grunde liegenden Messreihe auftretende niederfrequente Schwingung gezogen werden.

Vorzugsweise wird zu Grunde gelegt, dass das elektrische Versorgungsnetz eine Netzfrequenz mit einer Netzperiodenlänge aufweist, wobei dazu vorgeschlagen wird, dass die zweite Messreihe für einen von der Netzfrequenz abhängigen zweiten Messzeitraum aufgenommen wird, wobei der zweite Messzeitraum ein Vielfaches der Netzperiode ist. Als Vielfaches kann beispielsweise der zweite Messzeitraum der doppelten bis fünffachen Netzperiode entsprechen. Der Messzeitraum kann auch als Messfenster bezeichnet werden und die Wahl der Größe des Messzeitraumes bzw. des Messfensters kann auch als Fensterung bezeichnet werden. Hierdurch wird die Messung auch an den Frequenzbereich angepasst, in dem Frequenzen erfasst werden sollen. Hier wird besonders ein Frequenzbereich bis zur Netzfrequenz vorgeschlagen, bzw. bis zur Netznennfrequenz, wobei mehrere Periodendauern jeweils vollständig erfasst werden. Es ist hierbei besonders vorteilhaft, diese Periodendauern der Netzfrequenz, und damit die Periodendauern des Grundsignals, genau zu erfassen, um dadurch das Aufnehmen eines Gleichanteils zu vermeiden. Gegebenenfalls kann hier ausreichend sein, statt der Netzfrequenz die Netznennfrequenz zu verwenden, weil davon ausgegangen werden kann, dass die Netzfrequenz im Wesentlichen der Netznennfrequenz entspricht und daher etwaige Fehler oder Gleichanteile vergleichsweise gering bleiben.

Gemäß einer Ausführungsform wird vorgeschlagen, dass die erste und zweite Messreihe in sich wiederholenden Schleifen aufgenommen werden und die jeweilige Frequenzanalyse in jeder Schleife durchgeführt wird. Dadurch kann im Wesentlichen kontinuierlich auch für die jeweiligen Frequenzbereiche eine Analyse durchgeführt werden und entsprechend schnell eine niederfrequente Schwingung erfasst werden.

Insbesondere wird vorgeschlagen, dass die erste Messreihe in einer sich wiederholenden ersten Schleife aufgenommen wird und die Frequenzanalyse in der ersten Schleife durchgeführt wird, und dass die zweite Messreihe in einer sich wiederholenden zweiten Schleife aufgenommen wird und die Frequenzanalyse in der zweiten Schleife durchgeführt wird, wobei die zweite Schleife häufiger durchlaufen wird als die erste Schleife. Insbesondere wird die zweite Schleife wenigstens fünfmal so häufig durchlaufen wie die erste Schleife, bevorzugt wenigstens zehnmal so häufig.

Hier liegt besonders der Gedanke zugrunde, dass eine quasi kontinuierliche Überwachung und gegebenenfalls Erfassung niederfrequenter Schwingungen durchgeführt werden kann. Dabei wird berücksichtigt, dass dies sowohl für den unteren als auch den oberen Frequenzbereich durchgeführt wird, nämlich mittels der ersten bzw. zweiten Messreihe. Wie schon erläutert, können die unterschiedlichen Frequenzbereiche zu unterschiedlich aufgenommenen Messreihen führen und insbesondere auch zu zeitlich unterschiedlich langen Messreihen bzw. Messdauern. Dazu wird vorgeschlagen, jeder Messreihe mit anschließender Frequenzanalyse, also mit anschließender Auswertung, eine eigene Schleife zuzuordnen, in der dieser Prozess der Messaufnahme und Frequenzanalyse wiederholend durchgeführt wird. Diese Schleifen arbeiten nicht nur unabhängig voneinander, sondern werden auch unterschiedlich oft und damit auch unterschiedlich schnell durchlaufen.

Beispielsweise kann der Messzeitraum für die erste Messreihe 60-mal so lang sein wie der zweite Zeitraum für die zweite Messreihe. Dafür könnte entsprechend die zweite Schleife 60-mal so häufig durchlaufen werden wie die erste Schleife, es wurde aber erkannt, dass die Aufnahme und Auswertung der zweiten Messreihe, selbst wenn sie in einem Sechzigstel der Zeit wie die erste Messreihe aufgenommen wurde, aber nicht unbedingt in einem Sechzigstel der Zeit ausgewertet werden kann. Es ist aber vorteilhaft, die zweite Schleife zumindest fünfmal so häufig und damit im Ergebnis auch fünfmal so schnell durchlaufen zu lassen wie die erste, oder sogar wenigstens zehnmal so häufig und damit zehnmal so schnell wie die erste Schleife durchlaufen zu lassen.

Beide Schleifen liefern dann unabhängig voneinander Messergebnisse, bzw. Analyseergebnisse, und diese entstehen auch zu unterschiedlichen Zeitpunkten, die sich gegebenenfalls oder gelegentlich, zum Beispiel jedes fünfte oder zehnte Mal, entsprechen können, aber nicht müssen. Für die Gesamtauswertung kommt beispielsweise in Betracht, dass von jeder der beiden Schleifen, und damit für jeden der beiden Frequenzbereiche, jeweils das aktuellste Ergebnis zur weiteren Verarbeitung bereitsteht und dann jeweils mit einem neuen aktuellen Ergebnis überschrieben wird oder zumindest ein neues Ergebnis bereitgestellt wird, sobald dieses vorliegt. Auch hier wird somit vorgeschlagen, diese Ergebnisbereitstellung nicht für beide Schleifen oder beide Frequenzbereiche gleichzeitig zu machen, sondern je nach Bedarf und besonders je nachdem von welchem Frequenzbereich ein Ergebnis vorliegt. Damit kann eine nachfolgende Steuerung immer sehr aktuell auf aktuelle Ergebnisse zurückgreifen, obwohl für den ersten und zweiten Frequenzbereich eine Aktualisierung der Analyseergebnisse zu unterschiedlichen Zeiten und besonders unterschiedlich oft durchgeführt wird.

Gemäß einer Ausführungsform wird vorgeschlagen, dass der untere Frequenzbereich im Bereich von 0 bis 5 Hz liegt, vorzugsweise im Bereich von 0 bis 2 Hz und insbesondere von 0 bis 1 Hz. Damit kann der besonders niederfrequente Bereich abgedeckt werden und die Aufnahme der ersten Messreihe nebst Frequenzanalyse kann darauf abgestimmt sein.

Außerdem, oder alternativ, wird vorgeschlagen, dass der obere Frequenzbereich im Bereich von 0 Hz bis Netznennfrequenz liegt, insbesondere im Bereich von 0,5 Hz bis Netznennfrequenz. Hier wird der obere Frequenzbereich auf diesen hohen Frequenzbereich des Gesamtbereichs der zu erwartenden niederfrequenten Schwingungen ausgerichtet. Es kann besonders auch zweckmäßig sein, zwischen dem unteren und oberen Frequenzbereich einen Überschneidungsbereich zu haben. Bei dem Vorschlag, dass der obere Frequenzbereich bei 0,5 Hz beginnt, ergibt sich selbst bei dem kleinsten vorgeschlagenen Bereich für den unteren Frequenzbereich von 0 bis 1 Hz noch ein geringer Überschneidungsbereich. Damit wird besonders vermieden, dass niederfrequente Schwingungen mit einer Frequenz genau in diesem Grenzbereich zwischen unterem und oberem Frequenzbereich ungenügend erkannt werden. Grundsätzlich kann auch der obere Frequenzbereich von 0 Hz bis Netznennfrequenz vorgesehen sein, wobei bei den sehr geringen Frequenzen in Kauf genommen wird, dass die Messwerterfassung nicht ideal ist und für sehr geringe Frequenzen weniger als eine Halbwelle erfasst. Bei den höheren Frequenzen, beispielsweise ab 0,5 Hz, sollte dann aber möglichst das Messfenster, also der Messzeitraum, eine Halbwelle wenigstens umfassen.

Gemäß einer Ausführungsform wird vorgeschlagen, dass das Aufnehmen der Messreihen an einem Messpunkt erfolgt, der an einer an das elektrische Versorgungsnetz angeschlossenen Windenergieanlage angeordnet ist und/oder, der in einem an das elektrische Versorgungsnetz angeschlossenen Windpark angeordnet ist. Somit wird vorgesehen, dass die Messung im Ergebnis an der Windenergieanlage oder in dem Windpark erfolgt. Dort kann auch die Auswertung vorgenommen werden und das Ergebnis ist somit eine Information über niederfrequente Schwingungen, die für die Windenergieanlage bzw. den Windpark relevant sind. Besonders treten sie dort an dem Netzanschlusspunkt auf, in den die Windenergieanlage bzw. der Windpark einspeisen.

Grundsätzlich kommt auch in Betracht, dass der Messpunkt sowohl an der Windenergieanlage als auch in dem Windpark angeordnet ist, wenn diese Windenergieanlage, die den Messpunkt aufweist, nämlich Teil eines Windparks ist. Damit können die Ergebnisse des Verfahrens zum Erkennen niederfrequenter Schwingungen unmittelbar an der Windenergieanlage bzw. dem Windpark vorliegen und können dort auch unmittelbar verwendet werden, um, basierend auf diesen Ergebnissen, elektrische Wirkleistung und/oder elektrische Blindleistung in einer die erfassten Schwingungen dämpfenden Art und Weise einzuspeisen.

Vorzugsweise wird vorgeschlagen, abhängig der erkannten niederfrequenten Schwingungen einen Wirkleistungsanteil und/oder einen Blindleistungsanteil mit einer Frequenz einzuspeisen, die einer Frequenz eines identifizierten niederfrequenten Schwingungsanteils entspricht.

Vorzugsweise wird vorgeschlagen, dass das Aufnehmen der Messreihen so erfolgt, dass eine Spannung an einem Netzanschlusspunkt erfasst wird, an dem die Windenergieanlage bzw. der Windpark in das elektrische Versorgungsnetz einspeist. Es kann auch eine dazu äquivalente Größe erfasst werden. Besonders die Spannung am Netzanschlusspunkt kann Aufschluss über niederfrequente Schwingungen im elektrischen Versorgungsnetz geben und zwar besonders für einen für die Windenergieanlage bzw. den Windpark relevanten Abschnitt des elektrischen Versorgungsnetzes. Damit kann eine dort erfasste Spannung und somit dort erfasste niederfrequente Schwingung eine Basis sein für schwingungsdämpfende Maßnahmen durch die Windenergieanlage bzw. den Windpark.

Eine zu der Spannung am Netzanschlusspunkt äquivalente Größe kann beispielsweise auch eine Spannung an einer Niederspannungsseite eines Transformators sein, wenn seine Hochspannungsseite mit dem Netzanschlusspunkt verbunden ist. Auch die Spannung an einem Wechselrichterausgang einer Windenergieanlage oder eines Windparks kann eine zu der Spannung am Netzanschlusspunkt derselben Windenergieanlage bzw. desselben Windparks äquivalente Größe sein. Hier ist besonders zu beachten, dass es nicht unbedingt um eine akkurate Aufnahme der Spannung am Netzanschlusspunkt geht, sondern um das Erfassen niederfrequenter Schwingungen. Besonders die Frequenz einer solchen niederfrequenten Schwingung wird sich durch Übertragungselemente zwischen einem Wechselrichterausgang und einem Netzanschlusspunkt kaum ändern. Allenfalls Amplitude und Phasenlage könnte sich ändern. Eine solche Änderung von Amplitude und Phasenlage, je nach Frequenz, kann aber für eine Übertragungsstrecke bekannt sein und gegebenenfalls herausgerechnet werden.

Somit kann das Aufnehmen der Messreihen, das so erfolgt, dass eine Spannung an einem Netzanschlusspunkt erfasst wird, auch durch das Aufnehmen der Messreihen an einen Messpunkt an der Windenergieanlage oder in dem Windpark erfolgen.

Gemäß einer Ausführungsform wird vorgeschlagen, dass weitere Schritte vorgesehen sind, nämlich Aufnehmen wenigstens einer weiteren Messreihe, Durchführen jeweils einer weiteren Frequenzanalyse für die wenigstens eine weitere Messreihe jeweils für einen weiteren Frequenzbereich, wobei für den weiteren Frequenzbereich jeweils ein weiteres Amplitudenspektrum gebildet wird, und prüfen, ob in dem jeweiligen weiteren Amplitudenspektrum, ein niederfrequenter Schwingungsanteil identifiziert werden kann, wobei vom Vorliegen einer niederfrequenten Schwingung ausgegangen wird, wenn in wenigstens einem der Amplitudenspektren ein niederfrequenter Schwingungsanteil identifiziert wurde.

Es wurde erkannt, dass die bisher vorgeschlagene Aufteilung in zwei Frequenzbereiche, nämlich den unteren und oberen, und dafür die Aufnahme einer ersten und zweiten Messreihe auf einen dritten Frequenzbereich und sinngemäß auch auf noch weitere Frequenzbereiche erweitert werden kann. Entsprechend wird eine dritte Messreihe, bzw. noch weitere Messreihen aufgenommen und jeweils eine Frequenzanalyse durchgeführt. Dadurch kann besonders für die jeweiligen Frequenzbereiche zielgerichtet der Messzeitraum, also das Messfenster und darin die Abtastrate vorgegeben werden, um zielgerichtet in genau dem Frequenzbereich nach niederfrequenten Schwingungen zu suchen, indem dort zielgerichtet eine entsprechende Frequenzanalyse durchgeführt wird.

Entsprechend ist auch der wenigstens eine weitere Frequenzbereich einer, der einem Frequenzbereich für niederfrequente Schwingungen entspricht, insbesondere bis zur Netznennfrequenz reicht oder darunter liegt. Beispielsweise kann vorgesehen sein, dass nur ein weiterer Frequenzbereich gewählt wird, der insoweit auch als dritter Frequenzbereich bezeichnet werden kann, und dass dieser zwischen dem unteren und oberen Frequenzbereich eingefügt wird. Vorzugsweise kann dann der untere Frequenzbereich von 0 bis 0,5 Hz reichen, der dritte Frequenzbereich von 0,5 Hz bis 5 Hz und der zweite Frequenzbereich von 5 bis 50 Hz. Es können auch Überschneidungen vorgesehen sein und es können in diesem Sinne auch noch weitere Frequenzbereiche eingefügt und sinngemäß zur Analyse und Auswertung herangezogen werden.

Besonders kann vom Vorliegen einer niederfrequenten Schwingung ausgegangen werden, wenn in nur einem der Frequenzbereiche, also in nur einem der Amplitudenspektren ein niederfrequenter Schwingungsanteil identifiziert wird.

Vorzugsweis sind für unterschiedliche Messreihen unterschiedliche Auswertemethoden, insbesondere unterschiedliche Frequenzanalysen vorgesehen, insbesondere für jede Messreihe eine eigene Auswertemethode, insbesondere eigene Frequenzanalyse vorgesehen. Insbesondere wird vorgeschlagen, dazu die Auswertemethode jeweils auszuwählen aus den Möglichkeiten:
- FFT eines Spannungssignals,
- FFT eines Frequenzverlaufs und
- Waveletanalyse.

Hier wurde besonders erkannt, dass in den unterschiedlichen Messreihen unterschiedliche Frequenzbereiche zu Grunde liegen und dass in den unterschiedlichen Frequenzbereichen unterschiedliche Arten von Schwingungen auftreten können und insbesondere unterschiedliche Arten von Schwingungen zu erwarten sind, auf die die Frequenzanalyse auch der Art nach angepasst wird.

Erfindungsgemäß wird auch ein Windenergiesystem vorgeschlagen. Ein solches Windenergiesystem wird hier als Oberbegriff verstanden und betrifft entweder eine Windenergieanlage oder einen Windpark mit mehreren Windenergieanlagen. Dieses System ist zum Erkennen niederfrequenter Schwingungen vorgesehen, insbesondere zum Erkennen subsynchroner Resonanzen, nämlich in einem elektrischen Versorgungsnetz. Es wird dabei von einem elektrischen Versorgungsnetz ausgegangen, dass eine Netzspannung mit einer Netznennfrequenz aufweist, und dass die zu erkennenden niederfrequenten Schwingungen eine geringere Frequenz als die Netznennfrequenz aufweisen, insbesondere maximal eine halb so große Frequenz aufweisen wie die Netznennfrequenz. Das Windenergiesystem umfasst eine Aufnahmeeinrichtung zum Aufnehmen einer ersten und einer zweiten Messreihe, jeweils zum Durchführen einer Frequenzanalyse, insbesondere zum Durchführen einer FFT. Dazu kann die Aufnahmeeinrichtung besonders ein Spannungsmessmittel umfassen oder mit einem gekoppelt sein, um Spannungswerte in einem vorgebbaren Messzeitraum und mit einer vorgebbaren Abtastrate bzw. Abtastfrequenz aufzunehmen. Durch eine solche Art der Aufnahme der ersten und zweiten Messreihe, können diese Messreihen zum Durchführen einer Frequenzanalyse vorbereitet sein.

Zudem ist wenigstens ein erster und zweiter Frequenzanalysator vorgesehen. Der erste Frequenzanalysator ist zum Durchführen einer unteren Frequenzanalyse für die erste Messreihe für einen unteren Frequenzbereich vorgesehen, wobei für den unteren Frequenzbereich ein unteres Amplitudenspektrum gebildet wird. Der zweite Frequenzanalysator ist zum Durchführen einer oberen Frequenzanalyse für die zweite Messreihe für einen oberen Frequenzbereich vorgesehen, wobei für den oberen Frequenzbereich ein oberes Amplitudenspektrum gebildet wird. Somit wird für jede Messreihe, also zumindest die erste und die zweite, gegebenenfalls für eine dritte oder weitere Messreihe, durch den jeweiligen Frequenzanalysator die Frequenzanalyse durchgeführt. Dabei ist besonders zu beachten, dass den ersten und zweiten Frequenzanalysator, bzw. allgemein jedem der Frequenzanalysatoren, jeweils individuelle Randbedingungen zugrunde liegen, insbesondere unterschiedliche Zeitfenster nämlich Messfenster und Abtastraten, die teilweise durch die jeweils aufgenommene Messreihe vorgegeben sein können.

Der erste und zweite Frequenzanalysator können jeweils als Prozessrechner vorgesehen sein, um die Frequenzanalyse durchzuführen. Dazu kann jeder Frequenzanalysator seine jeweilige Messreihe erhalten. Es kommt aber auch in Betracht, dass die Frequenzanalysatoren in einem Prozessrechner kombiniert bzw. zusammengefasst sind und gegebenenfalls Teil eines Prozessrechners der Windenergieanlage bzw. des Windparks bilden, der zudem weitere Analyse- und/oder Steueraufgaben wahrnimmt und beispielsweise Steuersignale an einen Wechselrichter erzeugen und ausgeben kann. Dazu kann jeder Frequenzanalysator in dem Prozessrechner auch als Computerprogramm oder Analyseblock ausgebildet und dort implementiert sein, um die jeweiligen Messreihen jeweils auszuwerten.

In jedem Fall arbeiten aber die Frequenzanalysatoren, also wenigstens der erste und zweite Frequenzanalysator voneinander getrennt. Besonders können sie auch in unterschiedlichen Programmschleifen implementiert sein und in diesen Programmschleifen unterschiedlich oft aufgerufen werden, sodass insbesondere der erste Frequenzanalysator seltener durchlaufen wird als der zweite Frequenzanalysator.

Außerdem sind eine erste Prüfeinheit und eine zweite Prüfeinheit vorgesehen, gegebenenfalls weitere Prüfeinheiten. Die erste Prüfeinheit ist vorgesehen zum Prüfen, ob im unteren Amplitudenspektrum ein niederfrequenter Schwingungsanteil identifiziert werden kann, wobei die zweite Prüfeinheit vorgesehen ist zu prüfen, ob im oberen Amplitudenspektrum ein niederfrequenter Schwingungsanteil identifiziert werden kann. Somit wird für beide Amplitudenspektren, nämlich das untere und das obere, getrennt geprüft, ob ein niederfrequenter Schwingungsanteil vorhanden ist. Jede Prüfeinheit kann als eigenständige physikalische Vorrichtung ausgebildet sein, oder die Prüfeinheiten können zu einer Einheit zusammengefasst sein und darin jeweils eigenständig arbeiten. Besonders kann dafür ein Prozessrechner vorgesehen sein. Die Prüfeinheiten können auch in einem bereits vorhandenen Prozessrechner enthalten sein, bzw. in einem Prozessrechner, der noch weitere Aufgaben erfüllt. Besonders können die Prüfeinheiten auch als Softwareprogramm oder Programmeinheiten ausgebildet bzw. in einem Prozessrechner implementiert sein.

Außerdem wird eine Auswerteeinrichtung vorgeschlagen zum Auswerten, ob eine niederfrequente Schwingung vorliegt. Dabei wird vom Vorliegen einer niederfrequenten Schwingung ausgegangen, wenn im unteren und/oder oberen Amplitudenspektrum, oder in einem weiteren Amplitudenspektrum, ein niederfrequenter Schwingungsanteil identifiziert wurde. Auch die Auswerteeinheit kann als eigene Einheit oder als Softwarelösung in einen vorhandenen Prozessrechner implementiert sein. Die Auswerteeinheit betrachtet dabei die Ergebnisse für beide Frequenzbereiche bzw. gegebenenfalls für noch weitere Frequenzbereiche. Insoweit führt sie die Einzelergebnisse der einzelnen Frequenzbereiche, die also auf den jeweiligen Messreihen basieren, zusammen. Dadurch können die Frequenzbereiche und damit die einzelnen Messreihen individuell wie beschrieben betrachtet und ausgewertet, bzw. auch aufgenommen werden, und durch die Auswerteeinrichtung kann dann eine Zusammenführung der Ergebnisse vorgenommen werden.

Gemäß einer Ausführungsform wird vorgeschlagen, dass das Windenergiesystem eine Anlagensteuereinrichtung aufweist und die Anlagensteuereinrichtung dazu vorbereitet ist, ein Verfahren gemäß einem der vorstehend beschriebenen Ausführungsformen durchzuführen. Insbesondere kann dazu ein solches Verfahren in der Anlagensteuereinrichtung implementiert sein. Die Anlagensteuereinrichtung kann eine Windenergieanlagesteuereinrichtung sein, wenn das Windenergiesystem eine Windenergieanlage ist. Wenn das Windenergiesystem ein Windpark ist, kann die Anlagensteuereinrichtung eine zentrale Parksteuereinrichtung sein.

Gemäß einer Ausführungsform wird vorgeschlagen, dass das Windenergiesystem dadurch gekennzeichnet ist, dass
- eine erste Prozessschleife vorgesehen ist und die erste Prozessschleife dazu eingerichtet ist, wiederholt durchlaufen zu werden, wobei bei jedem Durchlauf die erste Messreihe aufgenommen wird, die untere Frequenzanalyse durchgeführt wird, ein unteres Amplitudenspektrum gebildet wird und geprüft wird, ob im unteren Amplitudenspektrum ein niederfrequenter Schwingungsanteil identifiziert werden kann,
- eine zweite Prozessschleife vorgesehen ist und die zweite Prozessschleife dazu eingerichtet ist, wiederholt durchlaufen zu werden, wobei bei jedem Durchlauf die zweite Messreihe aufgenommen wird, die obere Frequenzanalyse durchgeführt wird, ein oberes Amplitudenspektrum gebildet wird und geprüft wird, ob im oberen Amplitudenspektrum ein niederfrequenter Schwingungsanteil identifiziert werden kann, wobei
- die erste und zweite Prozessschleife so aufeinander abgestimmt sind bzw. in einem solchen Zusammenhang zueinanderstehen, dass die zweite Prozessschleife häufiger durchlaufen wird als die erste Prozessschleife, insbesondere, dass die zweite Prozessschleife wenigstens fünfmal so häufig durchlaufen wird, wie die erste Prozessschleife, insbesondere zehnmal so häufig.

Somit sind zwei unterschiedliche Prozessschleifen vorgesehen, die jeweils das Aufnehmen der Messreihe, das Durchführen der jeweiligen Frequenzanalyse und dabei das Bilden des jeweiligen Amplitudenspektrums durchführen und schließlich auch jeweils prüfen, ob ein niederfrequenter Schwingungsanteil identifiziert werden kann. Dadurch können zwei unabhängige Prozessschleifen auch die jeweiligen unterschiedlichen Messreihen und damit unterschiedlichen Frequenzbereiche entsprechend zielgerichtet bearbeiten. Besonders sind diese beiden Prozessschleifen insoweit voneinander unabhängig, dass sie voneinander unabhängig durchlaufen werden können, nämlich unterschiedlich häufig. Insoweit können die beiden Prozessschleifen aber in einen Gesamtprozess eingebunden sein, insbesondere in der Anlagensteuerung implementiert sein, dass das häufigere Durchlaufen der zweiten Prozessschleife erreicht wird, insbesondere durch die Anlagensteuereinrichtung erreicht wird.

Die Erfindung wird nun nachfolgend anhand von Ausführungsbeispielen exemplarisch unter Bezugnahme auf die begleitenden Figuren näher erläutert.
- Fig. 1: zeigt eine Windenergieanlage in einer perspektivischen Darstellung.
- Fig. 2: zeigt einen Windpark in einer schematischen Darstellung.
- Fig. 3: zeigt eine Anlagensteuereinrichtung einer Windenergieanlage oder eines Windparks in einer schematischen Darstellung.
- Fig. 4: beschreibt ein Ablaufdiagramm eines Verfahrens zum Erkennen niederfrequenter Schwingungen.
- Fig. 5: zeigt ein Spannungsspektrum einer Netzspannung veranschaulichend in einem Diagramm.
- Fig. 6: zeigt drei Diagramme zur Veranschaulichung eines Schwankungsspektrums.

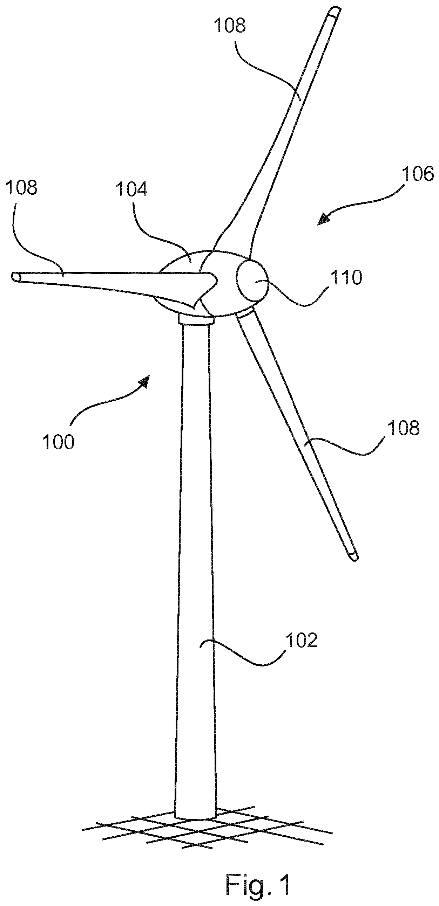

Figur 1 zeigt eine Windenergieanlage 100 mit einem Turm 102 und einer Gondel 104. An der Gondel 104 ist ein Rotor 106 mit drei Rotorblättern 108 und einem Spinner 110 angeordnet. Der Rotor 106 wird im Betrieb durch den Wind in eine Drehbewegung versetzt und treibt dadurch einen Generator in der Gondel 104 an.

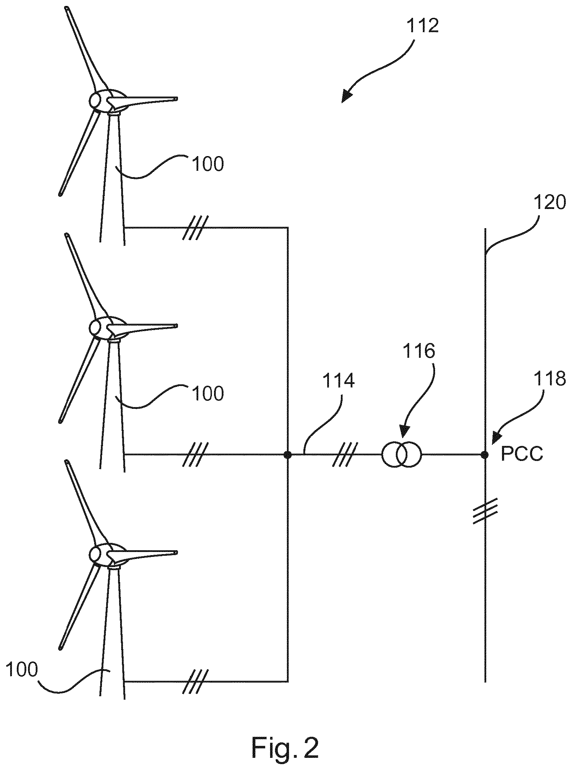

Figur 2 zeigt einen Windpark 112 mit beispielhaft drei Windenergieanlagen 100, die gleich oder verschieden sein können. Die drei Windenergieanlagen 100 stehen somit repräsentativ für im Grunde eine beliebige Anzahl von Windenergieanlagen eines Windparks 112. Die Windenergieanlagen 100 stellen ihre Leistung, nämlich insbesondere den erzeugten Strom über ein elektrisches Parknetz 114 bereit. Dabei werden die jeweils erzeugten Ströme bzw. Leistungen der einzelnen Windenergieanlagen 100 aufaddiert und meist ist ein Transformator 116 vorgesehen, der die Spannung im Park hochtransformiert, um dann an dem Einspeisepunkt 118, der auch allgemein als PCC bezeichnet wird, in das Versorgungsnetz 120 einzuspeisen. Fig. 2 ist nur eine vereinfachte Darstellung eines Windparks 112, die beispielsweise keine Steuerung zeigt, obwohl natürlich eine Steuerung vorhanden ist. Auch kann beispielsweise das Parknetz 114 anders gestaltet sein, indem beispielsweise auch ein Transformator am Ausgang jeder Windenergieanlage 100 vorhanden ist, um nur ein anderes Ausführungsbeispiel zu nennen.

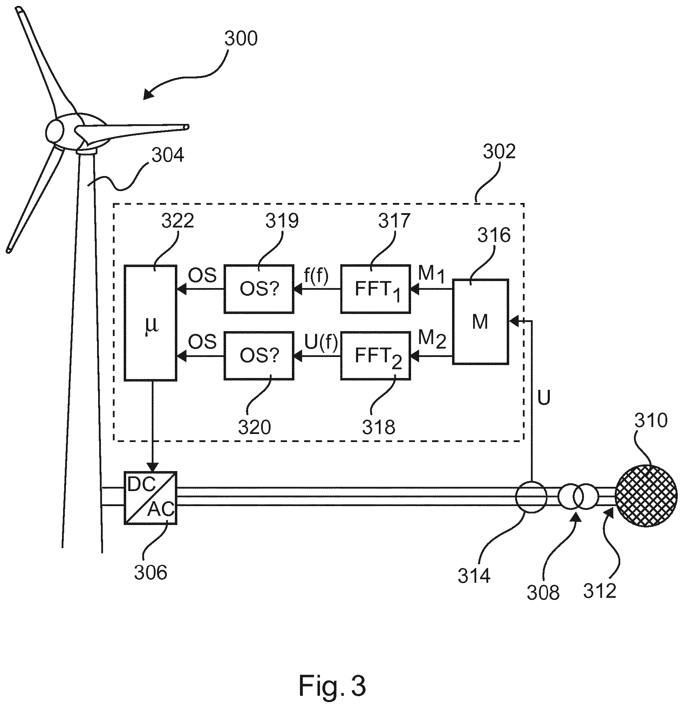

Fig. 3 zeigt schematisch eine Windenergieanlage 300, die auch einer Windenergieanlage 100 gemäß Fig. 1 oder Fig. 2 entsprechen kann und die im Übrigen auch repräsentativ für ein anderes Windenergiesystem stehen kann, insbesondere einen Windpark. Diese Windenergieanlage 300 umfasst eine Anlagensteuereinrichtung 302, die hier aus Gründen der besseren Darstellung außerhalb der eigentlichen Windenergieanlage 300 gezeigt ist, aber beispielsweise in dem Windenergieanlagenturm 304 untergebracht sein könnte. Die Anlagensteuereinrichtung 302 kann beispielsweise einen Wechselrichter 306 ansteuern, der einen dreiphasigen Ausgangsstrom erzeugen und über einen Transformator 308 in ein elektrisches Versorgungsnetz 310 einspeisen kann. Zwischen dem Transformator 308 und dem elektrischen Versorgungsnetz 310 kann ein Netzanschlusspunkt 312 liegen.

Zum Erkennen niederfrequenter Schwingungen wird mittels eines Messaufnehmers 314 eine elektrische Spannung erfasst und in die Anlagensteuereinrichtung 302 eingegeben. Die erfasste elektrische Spannung U entspricht im Wesentlichen einer elektrischen Spannung im elektrischen Versorgungsnetz 310, besonders an dem Netzanschlusspunkt 312, wobei ein Übersetzungsverhältnis des Transformators 308 zu berücksichtigen ist.

In der Anlagensteuereinrichtung 302 ist eine Aufnahmeeinrichtung 316 vorgesehen, die das Spannungssignal U des Messaufnehmers 314 erhält. Die Aufnahmeeinrichtung 316 kann dann von diesem Spannungssignal U eine erste und zweite Messreihe aufnehmen. Dazu kann für die beiden Messreihen jeweils ein unterschiedliches Zeitfenster und auch eine unterschiedliche Abtastrate vorgesehen sein. Die Aufnahmeeinrichtung 316 kann auch besonders für die erste Messreihe eine weitere Umwandlung oder Vorbereitung vornehmen, demnach als erste Messreihe ein zeitabhängiges Frequenzsignal erzeugt wird. Demnach kann die erste Messreihe M1 als zeitabhängiges Frequenzsignal f(t) ausgebildet sein, wohingegen die zweite Messreihe als zeitabhängiges Spannungssignal U(t) ausgebildet sein kann. Das wird jedenfalls gemäß der in Fig. 3 gezeigten Variante vorgeschlagen. Vorzugsweise bilden bereits diese erste und zweite Messreihe dennoch normierte Größen, um besser in einem Prozessrechner weiterverarbeitet werden zu können.

Die erste Messreihe wird dann in dem ersten Frequenzanalysator 317 eingegeben und dieser erste Frequenzanalysator 317 führt eine Frequenzanalyse durch, nämlich eine FFT, die als Ergebnis ein unteres Amplitudenspektrum ausgibt, nämlich ein Frequenzamplitudenspektrum f(f). Dieses Frequenzamplitudenspektrum f(f) bildet somit ein unteres Amplitudenspektrum und wird in die erste Prüfeinheit 319 eingegeben. Diese erste Prüfeinheit 319 prüft, ob in diesem unteren Amplitudenspektrum, also dem Frequenzamplitudenspektrum f(f) ein niederfrequenter Schwingungsanteil identifiziert werden kann und das Ergebnis einer oder mehrerer dabei erkannten Schwingungen wird an die Auswerteeinrichtung 322 gegeben. Solche Informationen über etwaige erkannte niederfrequente Schwingungen können besonders Amplitude, Frequenz und Phase der erfassten niederfrequenten Schwingungen umfassen, zumindest Frequenz und Amplitude.

In ähnlicher Weise wird die zweite Messreihe M2, die als zeitabhängiges Spannungssignal ausgebildet ist, an den zweiten Frequenzanalysator 318 gegeben. Der zweite Frequenzanalysator 318 führt eine Frequenzanalyse durch, nämlich eine FFT, und das Ergebnis ist ein oberes Amplitudenspektrum, nämlich ein Spannungsamplitudenspektrum U(f). Dieses Spannungsamplitudenspektrum U(f) wird an die zweite Prüfeinheit 320 gegeben und die prüft dann für dieses obere Amplitudenspektrum, ob ein niederfrequenter Schwingungsanteil identifiziert werden kann. Ein solcher, niederfrequenter Schwingungsanteil, das gilt sinngemäß auch für das untere Amplitudenspektrum, kann auch vereinfachend als niederfrequente Schwingung oder niederfrequentes Schwingungssignal bezeichnet werden. Das Ergebnis wird dann von der zweiten Prüfeinheit 320 ebenfalls an die Auswerteinrichtung 322 gegeben. Die Auswerteinrichtung 322 führt dann die Ergebnisse beider Analysen, also auch beider Messreihen, zusammen und kann somit insgesamt beurteilen, ob eine niederfrequente Schwingung vorliegt. Davon wird ausgegangen, wenn zumindest in einem der beiden untersuchten Amplitudenspektren, also im unteren Amplitudenspektrum oder im oberen Amplitudenspektrum, oder in beiden Amplitudenspektren, ein niederfrequenter Schwingungsanteil identifiziert wurde.

Gegebenenfalls kann die Auswerteinrichtung 322 dann darauf reagieren und, zur Kompensation oder zumindest Schwingungsdämpfung, ein entsprechendes Signal an den Wechselrichter 306 geben.

Sämtliche in der Anlagensteuereinrichtung 302 gezeigten Elemente, also besonders die Aufnahmeeinrichtung 316, die beiden Frequenzanalysatoren 317 und 318, die beiden Prüfeinheiten 319 und 320 und auch die Auswerteinrichtung 322 können auch in einem gemeinsamen Prozessrechner realisiert sein. Gegebenenfalls kann dazu in der Aufnahmeeinrichtung 316 ein Analog-Digital-Wandler, oder mehrere Analog-Digital-Wandler vorhanden sein, um aus der aufgenommenen Spannungsmessung die erste und zweite Messreihe zu erzeugen.

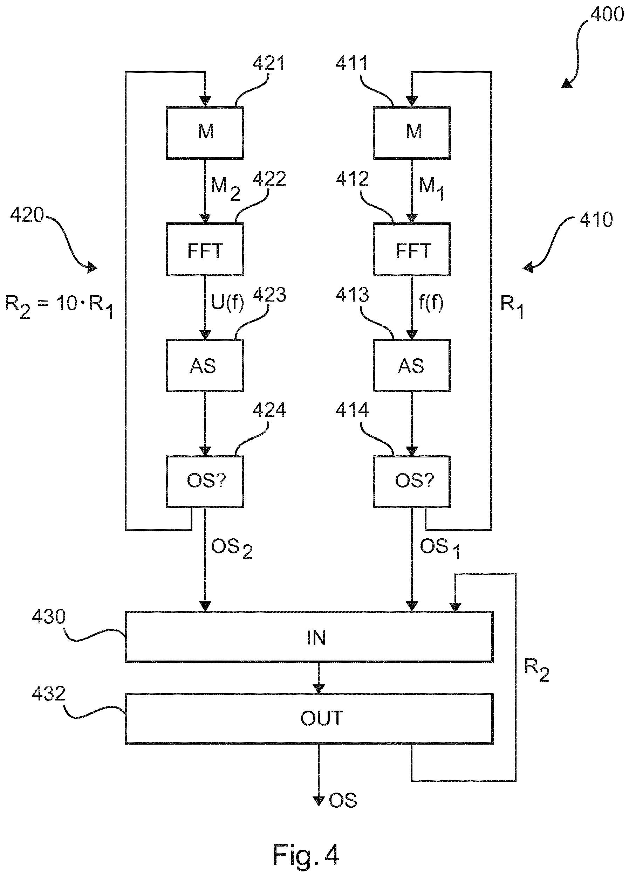

Fig. 4 zeigt schematisch ein Ablaufdiagramm 400 eines Verfahrens zum Erkennen niederfrequenter Schwingungen. Dieses Ablaufdiagramm 400 zeigt eine erste Prozessschleife 410 und eine zweite Prozessschleife 420. Beide Prozessschleifen 410, 420 arbeiten selbstständig und können auch nicht synchron zu einander durchlaufen werden, weisen aber viele ähnliche Elemente auf. Die erste Prozessschleife ist zum Auswerten eines unteren Frequenzbereichs vorgesehen. Sie führt in dem Aufnahmeblock 411 die Aufnahme einer ersten Messreihe durch. Das Ergebnis ist somit die erste Messreihe M1 und diese wird dann in dem Frequenzanalyseblock 412 in ihrer Frequenz analysiert und das Ergebnis ist ein Frequenzamplitudenspektrum f(f), das in den Amplitudenspektrumblock 413 weiter als Amplitudenspektrum dargestellt oder ausgewertet werden kann.

Darauf basierend schließt sich dann eine Prüfung im Prüfblock 414 an. Dabei wird geprüft, ob in dem Amplitudenspektrum eine niederfrequente Schwingung, bzw. ein niederfrequenter Schwingungsanteil identifiziert werden kann. Das Ergebnis dieser Prüfung kann von dem Prüfblock 414 an den Auswerteblock 430 als OS1-Signal ausgegeben werden.

Nach Durchlaufen dieser ersten Prozessschleife 410 kehrt der Prozessablauf am Ende des Prüfblocks 414 wieder zum Aufnahmeblock 411 zurück. Dies kann mit einer ersten Wiederholungsrate R1 erfolgen. Diese erste Wiederholungsrate R1 kann beispielsweise eine Wiederholung pro Minute betragen.

Die zweite Prozessschleife 420 ähnelt der ersten Prozessschleife 410, arbeitet von dieser aber unabhängig. Die zweite Prozessschleife 420 weist auch einen Aufnahmeblock 421 auf, in dem eine zweite Messreihe aufgenommen wird, um dann in dieser zweiten Prozessschleife 420 einen oberen Frequenzbereich auszuwerten. In dem Aufnahmeblock 421 wird somit die zweite Messreihe M2 erzeugt und die wird im Frequenzanalyseblock 422 weiterverarbeitet. Dort wird nämlich eine Frequenzanalyse durchgeführt und das Ergebnis ist ein frequenzabhängiges Spannungssignal U(f), das in dem Amplitudenspektrumblock 423 weiter ausgewertet werden kann. Dort kann nämlich ein Amplitudenspektrum aufgestellt, bzw. weiter aufbereitet werden.

Die zweite Prozessschleife 420 setzt dann in dem Prüfblock 424 fort und prüft dort in dem Amplitudenspektrum, ob eine niederfrequente Schwingung identifiziert werden kann, bzw. ob ein niederfrequenter Schwingungsanteil identifiziert werden kann. Das Ergebnis kann als zweite niederfrequente Schwingung OS2 an den Auswerteblock 430 übergeben werden.

Die zweite Prozessschleife 420 wird dann aber nach Abarbeitung des Prüfblocks 424 wieder von vorne in dem Aufnahmeblock 421 fortgesetzt und wiederholt. Diese zweite Prozessschleife 420 kann dabei mit einer zweiten Wiederholungsrate R2 durchlaufen werden. Die zweite Wiederholungsrate R2 ist dabei größer als die erste Wiederholungsrate R1 der ersten Prozessschleife 410. Beispielsweise kann die zweite Wiederholungsrate R2 zehnmal so groß sein wie die erste Wiederholungsrate R1. In dem genannten Beispiel beträgt dann also die zweite Wiederholungsrate R2 zehn Wiederholungen pro Minute. Die erste Prozessschleife 410 wird also einmal in einer Minute durchlaufen, wohingegen die zweite Prozessschleife 420 alle sechs Sekunden einmal durchlaufen wird.

Es ist auch möglich die beiden Prozessschleifen synchronisiert zu betreiben. Dabei wird beispielsweise nach dem Durchlaufen der ersten Prozessschleife auf das letztmalige Durchlaufen der zweiten Prozessschleife gewartet und die beiden Prozessschleifen werden dann synchron gestartet.

Somit erhält der Auswerteblock 430 zehnmal so häufig ein zweites Schwingungssignal OS2 von der zweiten Prozessschleife 420, wie es ein erstes Schwingungssignal OS1 von der ersten Prozessschleife erhält. Dafür kann der Auswerteblock 430 diese beiden Signale mit unterschiedlicher Häufigkeit empfangen und zwischenspeichern. Die jeweils aktuell vorliegenden Werte des ersten bzw. des zweiten Schwingungssignals OS1, OS2 führen jeweils zu einer Gesamtauswertung, die mittels des Ergebnisblocks 432 ausgegeben werden. Der Ergebnisblock 432 kann auch als Teil des Auswerteblocks 430 verstanden werden.

Es wird nun vorgeschlagen, dass die Prozesse des Auswerteblocks 430 und des Ergebnisblocks 432 ebenfalls wiederholt werden, wobei als Wiederholung auch die zweite Wiederholungsrate R2 vorgeschlagen wird, damit jeweils die aktuellen Werte der zweiten Prozessschleife 420 immer aktuell ausgewertet werden können. Bei jeder Wiederholung erhält der Auswerteblock 430 von der zweiten Prozessschleife 420, nämlich ihrem Prüfblock 424, ein aktuelles zweites Schwingungssignal OS2. Aber, um bei dem Beispiel zu bleiben, nur bei jeder zehnten Wiederholung ein aktuelles erstes Schwingungssignal OS1.

Dies wird bewusst in Kauf genommen, und die Auswertung in Auswerteblock 430 findet somit jeweils mit dem aktuellen zweiten Schwingungssignal OS2 und dem jeweils noch vorhandenen ersten Schwingungssignal OS1 statt, das somit, anschaulich gesprochen, in 9 von 10 Durchläufen ein altes Signal ist. Das beeinträchtigt den Prozess aber nicht, denn für das erste Schwingungssignal OS1 ist auch deutlich seltener, bzw. langsamer mit einer Änderung zu rechnen.

Der Ergebnisblock 432 kann dennoch für die hohe Wiederholungsrate, nämlich die zweite Wiederholungsrate R2 ein Gesamtergebnis als Gesamtschwingungssignal OS ausgeben.

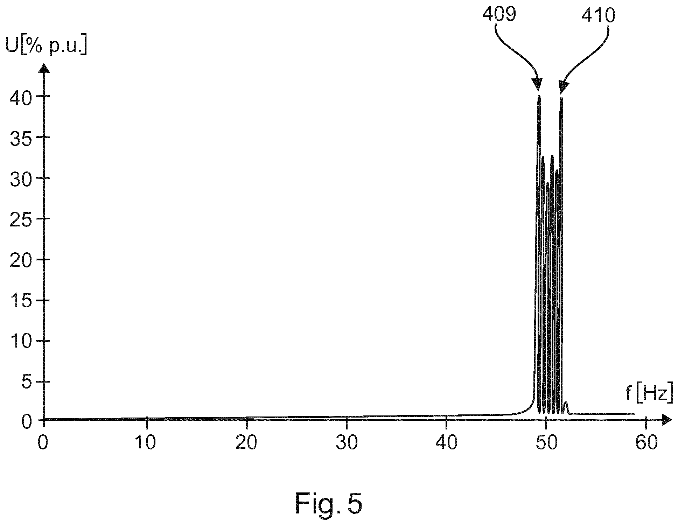

Als ein Variante kommt in Betracht, als Frequenzanalyse eine FFT der Netzspannung U aufzunehmen. Das kann für den oberen und den unteren Frequenzbereich durchgeführt werden, also für eine erste und eine zweite Messreihe. Die aufgenommene Netzspannung U bildet dann jeweils die erste bzw. zweite Messreihe. Das Ergebnis ist ein Spannungsspektrum, zu dem ein Beispiel in Figur 5 eingetragen ist. Dem Beispiel der Figur 5 liegt ein elektrisches Versorgungsnetz mit einer Nennfrequenz von 50 Hz zugrunde, was hier auch in etwa die Hauptfrequenz ist.

Besonders ist in dem Spannungsspektrum der Figur 5 zu erkennen, dass sich dieses im Wesentlichen um den Wert von 50 Hz gruppiert. Dabei gibt es aber genau bei 50 Hz, also genau bei der Nennfrequenz bzw. Hauptfrequenz, keinen singulären Häufigkeitsmaximalwert, sondern hier zwei die Nennfrequenz bzw. Hauptfrequenz flankierende lokale Maximalwerte 509 und 510. Zur Schätzung eines niederfrequenten Schwingungsanteils können diese beiden lokalen Maxima bzw. lokalen Maximalwerte ausgewertet werden und ihre Amplitude und/oder Amplitudenzunahme kann aussagen, ob eine niederfrequente Schwingung oder ein niederfrequenter Schwinganteil vorliegt.

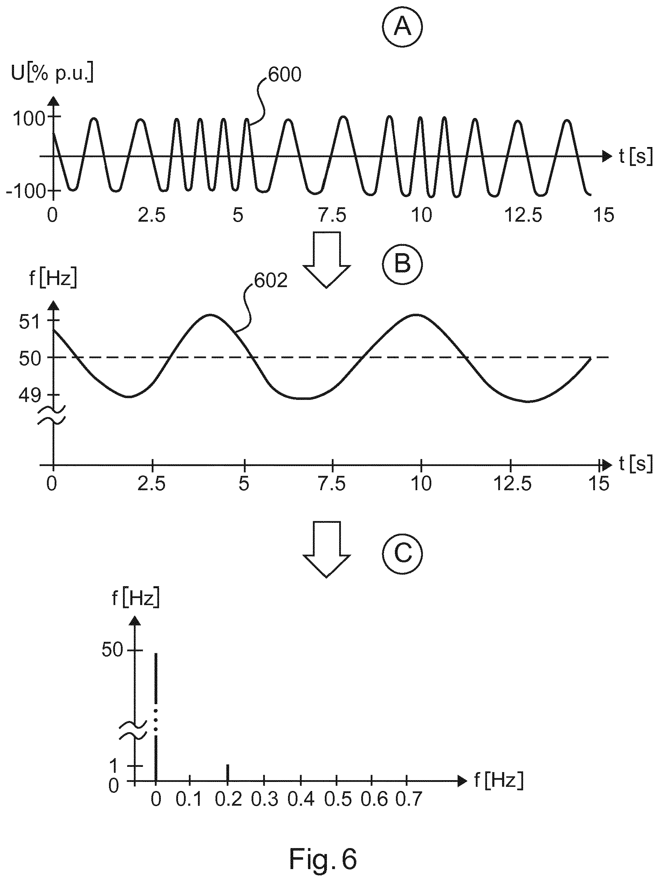

Eine noch weitere Variante, die mit den bisher beschriebenen auch kombiniert werden kann, besteht in der Auswertung eines Schwankungsspektrums. Das wird besonders als Auswertung der ersten Messreihe, also zum Analysieren eines unteren Frequenzbereichs vorgeschlagen. Zur Veranschaulichung enthält die Figur 6 dazu drei Diagramme A bis C.

Das erste Diagramm A veranschaulicht einen Spannungsverlauf, beispielsweise am Netzanschlusspunkt 118 gemäß Fig. 2. Dieser Spannungsverlauf ist schematisch zu verstehen und soll etwa einen Sinusverlauf mit schwankenden Frequenzen symbolisieren. Die Spannungskurve 600 weist daher, in überzeichneter Weise, verschieden lange Periodendauern auf. Die Spannungskurve 600 erinnert daher an eine Ziehharmonika. Jedenfalls soll dort verdeutlicht werden, dass diese Spannungskurve 600 in ihren Sinusverläufen über die Zeit t schwankt. Die Zeit t ist in dem Diagramm A von 0 bis 15 Sekunden aufgezeichnet. In dieser Zeit wechselt die Spannungskurve 600 etwa zweieinhalbmal zwischen langer und kurzer Periodendauer hin und her. Ihre Frequenz schwankt also in diesen 15 Sekunden etwa zweieinhalbmal hin und her.

Dies kann als ein Frequenzverlauf über die Zeit dargestellt werden, was in dem Diagramm B veranschaulicht ist. Das Diagramm B zeigt somit eine Frequenzkurve 602 über die Zeit. Es wird davon ausgegangen, dass sich ohne Frequenzschwankung eine feste Frequenz von 50 Hz eingestellt hätte. Insoweit wird nochmals wiederholt, dass das Diagramm A veranschaulichend ist. Tatsächlich ist, von den Schwankungen abgesehen, in dem Diagramm A ein Signal mit etwa 1 Hz gezeigt. Es wird dennoch davon ausgegangen, dass das Signal eine Grundfrequenz von 50 Hz aufweist, und insoweit das Diagramm A mit den etwa sinusförmigen Formen nur ein 50 Hz - Signal symbolisieren soll.

Jedenfalls ist in dem Diagramm B zu erkennen, dass die Frequenzkurve 602 um diese Hauptfrequenz von 50 Hz schwingt.

Dieses schwingende Signal, also diese schwingende Frequenzkurve 602 kann nun als Spektrum ausgewertet werden. Da in dem Diagramm B die Frequenz in Abhängigkeit der Zeit untersucht wird, ergibt sich bei der Übertragung in ein Spektrum eine Frequenz in Abhängigkeit einer Frequenz.

Das Diagramm C zeigt dieses zugehörige Frequenzspektrum. In dem Diagramm C ist also die Frequenz in Hz über die Frequenz in Hz abgetragen. Es ergibt sich ein Wert gemäß der Abszisse bei 0 Hz und dort beträgt die Amplitude 50 Hz. Die Grundschwingung hat also eine Amplitude von 50 Hz und sie verändert sich nicht und liegt deswegen bei 0 Hz. Außerdem schwankt die Frequenzkurve 602 des Diagramms B aber um diesen 50 Hz - Wert. Diese Schwankung ist so, dass sie von 49 bis 51 Hz schwankt. Die Schwankungsamplitude beträgt also 1 Hz. Außerdem schwankt sie zweimal in 10 Sekunden hin und her, so dass sich eine Frequenz von 0,2 Hz ergibt. Diese Schwankung der Frequenzkurve 602 des Diagramms B ist in der Spektraldarstellung des Diagramms C somit ein Wert mit der Amplitude 1 Hz bei einer Frequenz von 0,2 Hz.

Insoweit ist diese Untersuchung des Schwankungsspektrums auch eine niederfrequente Untersuchung. Diagramm C der Figur 6 ist aber ebenfalls nur veranschaulichend zu verstehen und grundsätzlich ist bei einer solchen Untersuchung des Schwankungsspektrums nicht nur mit einem einzigen Spektralwert zu rechnen, sondern mit mehreren Spektralwerten. Jedenfalls kann aus solchen Spektralwerten des im Diagramm C veranschaulichten Frequenzspektrums eine niederfrequente Schwingung erkannt werden. Die Schwankungsamplitude des Signals der Figur 6 ist gemäß der Darstellung im Diagramm C 1 Hz und ihr Wert liegt bei 0,2 Hz.

## Patentansprüche

1. Verfahren zum Erkennen niederfrequenter Schwingungen, insbesondere subsynchroner Resonanzen, in einem elektrischen Versorgungsnetz (120), wobei das elektrische Versorgungsnetz (120) eine Netzspannung (U) mit einer Netznennfrequenz aufweist, umfassend die Schritte
- Aufnehmen einer ersten und einer zweiten Messreihe (M1, M2), jeweils zum Durchführen einer Frequenzanalyse, insbesondere FFT,
- Durchführen einer unteren Frequenzanalyse für die erste Messreihe (M1) für einen unteren Frequenzbereich, wobei für den unteren Frequenzbereich ein unteres Amplitudenspektrum gebildet wird,
- Durchführen einer oberen Frequenzanalyse für die zweite Messreihe (M2) für einen oberen Frequenzbereich, wobei für den oberen Frequenzbereich ein oberes Amplitudenspektrum gebildet wird
- Prüfen, ob im unteren Amplitudenspektrum, ein niederfrequenter Schwingungsanteil identifiziert werden kann, und
- Prüfen, ob im oberen Amplitudenspektrums ein niederfrequenter Schwingungsanteil identifiziert werden kann, wobei
- vom Vorliegen einer niederfrequenten Schwingung ausgegangen wird, wenn in wenigstens einem des unteren und oberen Amplitudenspektrums ein niederfrequenter Schwingungsanteil identifiziert wird,
**dadurch gekennzeichnet, dass**
- die erste Messreihe (M1) über einen längeren Zeitraum als die zweite Messreihe (M2) aufgenommen wird oder ausgewertet wird, und/oder
- die erste Messreihe (M1) mit einer geringeren Abtastrate als die zweite Messreihe (M2) aufgenommen oder ausgewertet wird.

2. Verfahren nach Anspruch 1,
**dadurch gekennzeichnet, dass**
- die erste Messreihe (M1) über einen ersten Zeitraum aufgenommen wird, der in einem Bereich von 1 bis 10 Minuten liegt, und/oder
- die zweite Messreihe (M2) über einen zweiten Zeitraum aufgenommen wird, der in einem Bereich von 1 bis 10 Sekunden liegt.

3. Verfahren nach einem der vorstehenden Ansprüche,
**dadurch gekennzeichnet, dass**
- als erste Messreihe (M1) eine Frequenzmessung aufgenommen wird, sodass das erste Amplitudenspektrum Frequenzamplituden in Abhängigkeit einer Frequenz angibt, wobei insbesondere als Frequenzanalyse oder Teil davon eine Häufigkeit oder Häufigkeitsdichte der Frequenz (f) oder eines Frequenzgradienten der Frequenz erfasst wird und
- als zweite Messreihe (M2) eine Spannungsmessung aufgenommen wird, sodass das zweite Amplitudenspektrum Spannungsamplituden in Abhängigkeit einer Frequenz angibt.

4. Verfahren nach einem der vorstehenden Ansprüche,
**dadurch gekennzeichnet, dass**
das elektrische Versorgungsnetz (120) eine Netzfrequenz mit einer Netzperiodenlänge aufweist und
- die zweite Messreihe (M2) für einen von der Netzfrequenz abhängigen zweiten Messzeitraum aufgenommen wird, wobei der zweite Messzeitraum ein Vielfaches der Netzperiode ist.

5. Verfahren nach einem der vorstehenden Ansprüche,
**dadurch gekennzeichnet, dass**
- die erste und zweite Messreihe (M2) in sich wiederholenden Schleifen aufgenommen werden und die jeweilige Frequenzanalyse durchgeführt wird, insbesondere dass
- die erste Messreihe (M1) in einer sich wiederholenden ersten Schleife aufgenommen wird und die Frequenzanalyse durchgeführt wird, und dass
- die zweite Messreihe (M2) in einer sich wiederholenden zweiten Schleife aufgenommen wird und die Frequenzanalyse durchgeführt wird, wobei
- die zweite Schleife häufiger durchlaufen wird, als die erste Schleife, insbesondere dass die zweite Schleife wenigstens 5 mal so häufig durchlaufen wird, wie die erste Schleife, insbesondere wenigstens 10 mal so häufig.

6. Verfahren nach einem der vorstehenden Ansprüche,
**dadurch gekennzeichnet, dass**
- der untere Frequenzbereich im Bereich von 0 bis 5Hz, vorzugsweise im Bereich von 0 bis 2Hz und insbesondere von 0 bis 1 Hz liegt und/oder
- der obere Frequenzbereich im Bereich von 0Hz bis Netznennfrequenz, insbesondere im Bereich von 0,5Hz bis Netznennfrequenz liegt.

7. Verfahren nach einem der vorstehenden Ansprüche,
**dadurch gekennzeichnet, dass**
das Aufnehmen der Messreihen an einem Messpunkt erfolgt, der
- an einer an das elektrische Versorgungsnetz (120) angeschlossenen Windenergieanlage (100) angeordnet ist, und/oder
- in einem an das elektrische Versorgungsnetz (120) angeschlossenen Windpark (112) angeordnet ist und/oder
- dass das Aufnehmen der Messreihen so erfolgt, dass eine Spannung an einem Netzanschlusspunkt (118) erfasst wird, an dem die Windenergieanlage (100) bzw. der Windpark (112) in das elektrische Versorgungsnetz (120) einspeist, oder eine dazu äquivalente Größe.

8. Verfahren nach einem der vorstehenden Ansprüche,
**gekennzeichnet durch** die Schritte
- Aufnehmen wenigstens einer weiteren Messreihe,
- Durchführen jeweils einer weiteren Frequenzanalyse für die wenigstens eine weitere Messreihe jeweils für einen weiteren Frequenzbereich, wobei für den weiteren Frequenzbereich jeweils ein weiteres Amplitudenspektrum gebildet wird, und
- Prüfen, ob in dem jeweiligen weiteren Amplitudenspektrum ein niederfrequenter Schwingungsanteil identifiziert werden kann, wobei
- vom Vorliegen einer niederfrequenten Schwingung ausgegangen wird, wenn in wenigstens einem der Amplitudenspektren ein niederfrequenter Schwingungsanteil identifiziert wird.

9. Windenergiesystem, nämlich Windenergieanlage (100) oder Windpark (112), zum Erkennen niederfrequenter Schwingungen, insbesondere subsynchroner Resonanzen, in einem elektrischen Versorgungsnetz (120), wobei das elektrische Versorgungsnetz (120) eine Netzspannung mit einer Netznennfrequenz aufweist und das Windenergiesystem umfasst:
- eine Aufnahmeeinrichtung zum Aufnehmen einer ersten und einer zweiten Messreihe (M1, M2), jeweils zum Durchführen einer Frequenzanalyse, insbesondere FFT,
- einen ersten Frequenzanalysator zum Durchführen einer unteren Frequenzanalyse für die erste Messreihe für einen unteren Frequenzbereich, wobei für den unteren Frequenzbereich ein unteres Amplitudenspektrum gebildet wird,
- einen zweiten Frequenzanalysator zum Durchführen einer oberen Frequenzanalyse für die zweite Messreihe für einen oberen Frequenzbereich, wobei für den oberen Frequenzbereich ein oberes Amplitudenspektrum gebildet wird,
- erste Prüfeinheit zum Prüfen, ob im unteren Amplitudenspektrum ein niederfrequenter Schwingungsanteil identifiziert werden kann,
- zweite Prüfeinheit zum Prüfen, ob im oberen Amplitudenspektrums ein niederfrequenter Schwingungsanteil identifiziert werden kann, und
- eine Auswerteeinrichtung zum Auswerten, ob eine niederfrequente Schwingung vorliegt, wobei vom Vorliegen einer niederfrequenten Schwingung ausgegangen wird, wenn im unteren und/oder oberen Amplitudenspektrum ein niederfrequenter Schwingungsanteil identifiziert wurde,
**dadurch gekennzeichnet, dass**
- die erste Messreihe (M1) über einen längeren Zeitraum als die zweite Messreihe (M2) aufgenommen wird oder ausgewertet wird, und/oder
- die erste Messreihe (M1) mit einer geringeren Abtastrate als die zweite Messreihe (M2) aufgenommen oder ausgewertet wird.

10. Windenergiesystem nach Anspruch 9, **dadurch gekennzeichnet, dass**
- eine Anlagensteuereinrichtung (302) vorgesehen ist und
- die Anlagensteuereinrichtung (302) dazu vorbereitet ist, ein Verfahren nach einem der Ansprüche 1 bis 9 durchzuführen.

11. Windenergiesystem nach Anspruch 9 oder 10, **dadurch gekennzeichnet, dass**
- eine erste Prozessschleife (410) vorgesehen ist und die erste Prozessschleife dazu eingerichtet ist, wiederholt durchlaufen zu werden, wobei bei jedem Durchlauf die erste Messreihe (M1) aufgenommen wird, die untere Frequenzanalyse durchgeführt wird, ein unteres Amplitudenspektrum gebildet wird und geprüft wird, ob im unteren Amplitudenspektrum ein niederfrequenter Schwingungsanteil identifiziert werden kann, und
- eine zweite Prozessschleife (420) vorgesehen ist und die zweite Prozessschleife dazu eingerichtet ist, wiederholt durchlaufen zu werden, wobei bei jedem Durchlauf die zweite Messreihe (M2) aufgenommen wird, die obere Frequenzanalyse durchgeführt wird, ein oberes Amplitudenspektrum gebildet wird und geprüft wird, ob im oberen Amplitudenspektrum ein niederfrequenter Schwingungsanteil identifiziert werden kann, wobei
- die erste und die zweite Prozessschleife (410, 420) so aufeinander abgestimmt sind bzw. in einem solchen Zusammenhang zueinanderstehen, dass die zweite Prozessschleife (420) häufiger durchlaufen wird, als die erste Prozessschleife (410), insbesondere dass die zweite Prozessschleife (420) wenigstens 5 mal so häufig durchlaufen wird, wie die erste Prozessschleife (410), insbesondere wenigstens 10 mal so häufig.

## Claims

1. A method for detecting low-frequency oscillations, in particular subsynchronous resonances, in an electrical supply grid (120), wherein the electrical supply grid (120) has a line voltage (U) with a rated line frequency, comprising the steps of
- recording a first and a second series of measurements (M1, M2), in each case for performing a frequency analysis, in particular FFT,
- performing a lower frequency analysis for the first series of measurements (M1) for a lower frequency range, wherein a lower amplitude spectrum is formed for the lower frequency range,
- performing an upper frequency analysis for the second series of measurements (M2) for an upper frequency range, wherein an upper amplitude spectrum is formed for the upper frequency range,
- testing whether a low-frequency oscillation component can be identified in the lower amplitude spectrum, and
- testing whether a low-frequency oscillation component can be identified in the upper amplitude spectrum, wherein
- the presence of a low-frequency oscillation is assumed when a low-frequency oscillation component is identified in at least one of the lower and upper amplitude spectra
**characterized in that**
- the first series of measurements (M1) is recorded or is evaluated over a longer time period than the second series of measurements (M2), and/or
- the first series of measurements (M1) is recorded or is evaluated at a lower sampling rate than the second series of measurements (M2).

2. The method as claimed in claim 1,
**characterized in that**
- the first series of measurements (M1) is recorded over a first time period, which is in a range of from 1 to 10 minutes, and/or
- the second series of measurements (M2) is recorded over a second time period, which is in a range of from 1 to 10 seconds.

3. The method as claimed in one of the preceding claims,
**characterized in that**
- a frequency measurement is recorded as the first series of measurements (M1), with the result that the first amplitude spectrum specifies frequency amplitudes depending on a frequency, wherein, in particular as frequency analysis or part thereof, a rate or frequency density of the frequency (f) or of a frequency gradient of the frequency is detected, and
- a voltage measurement is recorded as the second series of measurements (M2), with the result that the second amplitude spectrum specifies voltage amplitudes depending on a frequency.

4. The method as claimed in one of the preceding claims,
**characterized in that**
the electrical supply grid (120) has a line frequency with a grid period length, and
- the second series of measurements (M2) is recorded for a second measurement time period which is dependent on the line frequency, wherein the second measurement time period is a multiple of the grid period.

5. The method as claimed in one of the preceding claims,
**characterized in that**
- the first and second series of measurements (M2) are recorded in self-repeating loops, and the respective frequency analysis is performed, in particular **in that**
- the first series of measurement (M1) is recorded in a self-repeating first loop, and the frequency analysis is performed, and **in that**
- the second series of measurements (M2) is recorded in a self-repeating second loop, and the frequency analysis is performed, wherein
- the second loop is run more often than the first loop, in particular **in that** the second loop is run at least 5 times as often as the first loop, in particular at least 10 times as often.

6. The method as claimed in one of the preceding claims,
**characterized in that**
- the lower frequency range is in the range of from 0 to 5 Hz, preferably in the range of from 0 to 2 Hz, and in particular from 0 to 1 Hz and/or
- the upper frequency range is in the range of from 0 Hz to the rated line frequency, in particular in the range of from 0.5 Hz to the rated line frequency.

7. The method as claimed in one of the preceding claims,
**characterized in that**
the recording of the series of measurements takes place at a measurement point, which
- is arranged on a wind turbine (100) connected to the electrical supply grid (120), and/or
- is arranged in a wind farm (112) connected to the electrical supply grid (120), and/or
- **in that** the recording of the series of measurements takes place in such a way that a voltage is detected at a grid connection point (118) at which the wind turbine (100) or the wind farm (112) injects into the electrical supply grid (120) or a variable equivalent thereto.

8. The method as claimed in one of the preceding claims,
**characterized by** the steps of
- recording at least one further series of measurements,
- performing in each case one further frequency analysis for the at least one further series of measurements in each case for a further frequency range, wherein in each case one further amplitude spectrum is formed for the further frequency range, and
- testing whether a low-frequency oscillation component can be identified in the respective further amplitude spectrum, wherein
- the presence of a low-frequency oscillation is assumed when a low-frequency oscillation component is identified in at least one of the amplitude spectra.

9. A wind power system, namely a wind turbine (100) or wind farm (112), for detecting low-frequency oscillations, in particular subsynchronous resonances, in an electrical supply grid (120), wherein the electrical supply grid (120) has a line voltage with a rated line frequency, and the wind power system comprises:
- a recording device for recording a first and a second series of measurements (M1, M2), in each case for performing a frequency analysis, in particular FFT,
- a first frequency analyzer for performing a lower frequency analysis for the first series of measurements for a lower frequency range, wherein a lower amplitude spectrum is formed for the lower frequency range,
- a second frequency analyzer for performing an upper frequency analysis for the second series of measurements for an upper frequency range, wherein an upper amplitude spectrum is formed for the upper frequency range,
- first test unit for testing whether a low-frequency oscillation component can be identified in the lower amplitude spectrum,
- second test unit for testing whether a low-frequency oscillation component can be identified in the upper amplitude spectrum, and
- an evaluation device for evaluating whether there is a low-frequency oscillation, wherein the presence of a low-frequency oscillation is assumed when a low-frequency oscillation component has been identified in the lower and/or upper amplitude spectrum,
**characterized in that**
- the first series of measurements (M1) is recorded or is evaluated over a longer time period than the second series of measurements (M2), and/or
- the first series of measurements (M1) is recorded or is evaluated at a lower sampling rate than the second series of measurements (M2).

10. The wind power system as claimed in claim 9,
**characterized in that**
- an installation control device (302) is provided, and
- the installation control device (302) is set up to implement a method as claimed in one of claims 1 to 9.

11. The wind power system as claimed in claim 9 or 10,
**characterized in that**
- a first process loop (410) is provided, and the first process loop is designed to be run repeatedly, wherein, on each run, the first series of measurements (M1) is recorded, the lower frequency analysis is performed, a lower amplitude spectrum is formed, and a test is performed to ascertain whether a low-frequency oscillation component can be identified in the lower amplitude spectrum, and
- a second process loop (420) is provided, and the second process loop is designed to be run repeatedly, wherein, on each run, the second series of measurements (M2) is recorded, the upper frequency analysis is performed, an upper amplitude spectrum is formed, and a test is performed to ascertain whether a low-frequency oscillation component can be identified in the upper amplitude spectrum, wherein
- the first and the second process loops (410, 420) are matched to one another in such a way or have such a relationship to one another that the second process loop (420) is run more often than the first process loop (410), in particular that the second process loop (420) is run at least 5 times as often as the first process loop (410), in particular at least 10 times as often.

## Revendications

1. Procédé de détection d'oscillations basse fréquence, en particulier de résonances sous-synchrones, dans un réseau d'alimentation électrique (120), dans lequel le réseau d'alimentation électrique (120) présente une tension de réseau (U) avec une fréquence nominale de réseau, comprenant les étapes
- d'enregistrement d'une première et d'une seconde série de mesures (M1, M2), respectivement pour réaliser une analyse de fréquences, en particulier une FFT,
- de réalisation d'une analyse de fréquences inférieures pour la première série de mesures (M1) pour une plage de fréquences inférieures, dans lequel un spectre d'amplitudes inférieures est formé pour la plage de fréquences inférieures,
- de réalisation d'une analyse de fréquences supérieures pour la seconde série de mesures (M2) pour une plage de fréquences supérieures, dans lequel un spectre d'amplitudes supérieures est formé pour la plage de fréquences supérieures
- de contrôle quant à savoir si une fraction d'oscillation basse fréquence peut être identifiée dans le spectre d'amplitudes inférieures, et
- de contrôle quant à savoir s'il est possible d'identifier une fraction d'oscillation basse fréquence dans le spectre d'amplitudes supérieures, dans lequel
- la présence d'une oscillation basse fréquence est supposée si une fraction d'oscillation basse fréquence est identifiée dans au moins l'un du spectre d'amplitudes inférieures et supérieures,
**caractérisé en ce que**
- la première série de mesures (M1) est enregistrée ou est évaluée sur un laps de temps plus long que la seconde série de mesures (M2), et/ou
- la première série de mesures (M1) est enregistrée ou évaluée avec un taux d'échantillonnage inférieur à celui de la seconde série de mesures (M2).

2. Procédé selon la revendication 1,
**caractérisé en ce que**
- la première série de mesures (M1) est enregistrée sur un premier laps de temps qui se situe dans une plage de 1 à 10 minutes, et/ou
- la seconde série de mesures (M2) est enregistrée sur un second laps de temps qui se situe dans une plage de 1 à 10 secondes.

3. Procédé selon l'une quelconque des revendications précédentes,
**caractérisé en ce que**
- une mesure de fréquence est enregistrée en tant que première série de mesures (M1), de sorte que le premier spectre d'amplitudes indique des amplitudes de fréquence en fonction d'une fréquence, dans lequel une périodicité ou densité de périodicité de la fréquence (f) ou d'un gradient de fréquence de la fréquence est en particulier acquise en tant qu'analyse de fréquence ou partie de celle-ci et
- une mesure de tension est enregistrée en tant que seconde série de mesures (M2), de sorte que le second spectre d'amplitudes indique des amplitudes de tension en fonction d'une fréquence.

4. Procédé selon l'une quelconque des revendications précédentes,
**caractérisé en ce que**
le réseau d'alimentation électrique (120) présente une fréquence de réseau avec une longueur de période du réseau et
- la seconde série de mesures (M2) est enregistrée pour un second laps de temps de mesures dépendant de la fréquence du réseau, dans lequel le second laps de temps de mesures est un multiple de la période du réseau.

5. Procédé selon l'une quelconque des revendications précédentes,
**caractérisé en ce que**
- les première et seconde séries de mesures (M2) sont enregistrées en boucles répétitives et l'analyse de fréquence respective est réalisée, en particulier que
- la première série de mesures (M1) est enregistrée dans une première boucle répétitive et l'analyse de fréquence est réalisée, et que
- la seconde série de mesures (M2) est enregistrée dans une seconde boucle répétitive et l'analyse de fréquence est réalisée, dans lequel
- la seconde boucle est parcourue plus fréquemment que la première boucle, en particulier que la seconde boucle est parcourue au moins 5 fois plus souvent que la première boucle, en particulier au moins 10 fois plus souvent.

6. Procédé selon l'une quelconque des revendications précédentes,
**caractérisé en ce que**
- la plage de fréquences inférieures se situe dans la plage de 0 à 5 Hz, de préférence dans la plage de 0 à 2 Hz et en particulier de 0 à 1 Hz et/ou
- la plage de fréquences supérieures se situe dans la plage de 0 Hz à la fréquence nominale du réseau, en particulier dans la plage de 0,5 Hz à la fréquence nominale du réseau.

7. Procédé selon l'une quelconque des revendications précédentes,
**caractérisé en ce que**
l'enregistrement des séries de mesures s'effectue à un point de mesure qui
- est situé sur une éolienne (100) raccordée au réseau d'alimentation électrique (120), et/ou
- est situé dans un parc éolien (112) raccordé au réseau d'alimentation électrique (120) et/ou
- que l'enregistrement des séries de mesures s'effectue de sorte qu'une tension est acquise à un point de raccordement au réseau (118) au niveau duquel l'éolienne (100) ou le parc éolien (112) effectue une injection dans le réseau d'alimentation électrique (120), ou une grandeur équivalente à celle-ci.

8. Procédé selon l'une quelconque des revendications précédentes,
**caractérisé par** les étapes
- d'enregistrement d'au moins une autre série de mesures,
- de réalisation de respectivement une analyse de fréquences supplémentaire pour l'au moins une autre série de mesures respectivement pour une plage de fréquences supplémentaire, dans lequel un autre spectre d'amplitudes est formé respectivement pour la plage de fréquences supplémentaire, et
- de contrôle quant à savoir si une fraction d'oscillation basse fréquence peut être identifiée dans le spectre d'amplitudes supplémentaire respectif, dans lequel
- la présence d'une oscillation basse fréquence est supposée si une fraction d'oscillation basse fréquence est identifiée dans au moins l'un des spectres d'amplitudes.

9. Système d'énergie éolienne, à savoir éolienne (100) ou parc éolien (112), pour détecter des oscillations basse fréquence, en particulier des résonances sous-synchrones, dans un réseau d'alimentation électrique (120), dans lequel le réseau d'alimentation électrique (120) présente une tension de réseau avec une fréquence nominale de réseau et le système d'énergie éolienne comprend :
- un dispositif d'enregistrement pour l'enregistrement d'une première et d'une seconde série de mesures (M1, M2), respectivement pour réaliser une analyse de fréquences, en particulier une FFT,
- un premier analyseur de fréquences pour réaliser une analyse de fréquences inférieures pour la première série de mesures pour une plage de fréquences inférieures, dans lequel un spectre d'amplitudes inférieures est formé pour la plage de fréquences inférieures,
- un second analyseur de fréquences pour réaliser une analyse de fréquences supérieures pour la seconde série de mesures pour une plage de fréquences supérieures, dans lequel un spectre d'amplitudes supérieures est formé pour la plage de fréquences supérieures,
- une première unité de contrôle pour contrôler si une fraction d'oscillation basse fréquence peut être identifiée dans le spectre d'amplitudes inférieures,
- une seconde unité de contrôle pour contrôler si une fraction d'oscillation basse fréquence peut être identifiée dans le spectre d'amplitudes supérieures, et
- un dispositif d'évaluation pour évaluer si une oscillation basse fréquence est présente, dans lequel la présence d'une oscillation basse fréquence est supposée si une fraction d'oscillation basse fréquence a été identifiée dans le spectre d'amplitudes inférieures et/ou supérieures,
**caractérisé en ce que**
- la première série de mesures (M1) est enregistrée ou est évaluée sur un laps de temps plus long que la seconde série de mesures (M2), et/ou
- la première série de mesures (M1) est enregistrée ou évaluée avec un taux d'échantillonnage inférieur à celui de la seconde série de mesures (M2).

10. Système éolien selon la revendication 9,
**caractérisé en ce que**
- un dispositif de commande d'éolienne (302) est prévu et
- le dispositif de commande d'éolienne (302) est préparé pour réaliser un procédé selon l'une quelconque des revendications 1 à 9.

11. Système éolien selon la revendication 9 ou 10,
**caractérisé en ce que**
- une première boucle de processus (410) est prévue et la première boucle de processus est configurée pour être parcourue de manière répétée, dans lequel, à chaque passage, la première série de mesures (M1) est enregistrée, l'analyse de fréquences inférieures est réalisée, un spectre d'amplitudes inférieures est formé et on contrôle si une fraction d'oscillation basse fréquence peut être identifiée dans le spectre d'amplitudes inférieures, et
- une seconde boucle de processus (420) est prévue et la seconde boucle de processus est configurée pour être parcourue de manière répétée, dans lequel, à chaque passage, la seconde série de mesures (M2) est enregistrée, l'analyse de fréquences supérieures est réalisée, un spectre d'amplitudes supérieures est formé et on contrôle si une fraction d'oscillation basse fréquence peut être identifiée dans le spectre d'amplitudes supérieures, dans lequel
- la première et la seconde boucle de processus (410, 420) sont harmonisées l'une par rapport à l'autre ou se trouvent l'une avec l'autre dans une relation telle que la seconde boucle de processus (420) est parcourue plus souvent que la première boucle de processus (410), en particulier que la seconde boucle de processus (420) est parcourue au moins 5 fois plus souvent que la première boucle de processus (410), en particulier au moins 10 fois plus souvent.
